# EUROPEAN PATENT SPECIFICATION

(11) **EP 1 867 687 B1**
(45) Date of publication and mention of the grant of the patent: **12.06.2013**
(21) Application number: 06729340.7
(22) Date of filing: 17.03.2006
(51) Int. Cl.: C09D 7/12, C09D 183/00, H01L 21/316

(54) **PRECURSOR COMPOSITION FOR POROUS MEMBRANE AND PROCESS FOR PREPARATION THEREOF, POROUS MEMBRANE AND PROCESS FOR PRODUCTION THEREOF, AND SEMICONDUCTOR DEVICE**
VORGÄNGERZUSAMMENSETZUNG FÜR PORÖSE MEMBRAN UND IHRE HERSTELLUNG, PORÖSE MEMBRAN UND IHRE HERSTELLUNG SOWIE HALBLEITERVORRICHTUNG
COMPOSITION DE PRECURSEUR POUR UNE MEMBRANE POREUSE ET PROCEDE POUR SA PREPARATION, MEMBRANE POREUSE ET PROCEDE POUR SA FABRICATION ET DISPOSITIF SEMI-CONDUCTEUR

(30) Priority: 23.03.2005 JP 2005084206
(43) Date of publication of application: 19.12.2007
(73) Proprietor: ULVAC, INC., Chigasaki-shi, Kanagawa 253-8543 (JP); National Institute of Advanced Industrial Science and Technology, Tokyo 100-8921 (JP)
(72) Inventor: FUJII, Nobutoshi, Ibaraki 3002635 (JP); NAKAYAMA, Takahiro, Ibaraki 3002635 (JP); KANAYAMA, Toshihiko, Ibaraki 3058569 (JP); KOHMURA, Kazuo, Chiba 2990265 (JP); TANAKA, Hirofumi, Chiba 2990265 (JP)
(74) Representative: Störzbach, Michael Andreas
(86) International application number: PCT/JP2006/305350
(87) International publication number: WO 2006/101027

(56) References cited:
- JP-A- 11 246 665
- JP-A- 2000 077 399
- JP-A- 2001 226 171
- JP-A- 2001 240 673
- JP-A- 2002 026 003
- JP-A- 2002 201 415
- JP-A- 2003 183 575
- JP-A- 2003 277 042
- JP-A- 2003 306 639
- JP-A- 2004 002 579
- JP-A- 2004 051 899
- JP-A- 2004 165 401
- JP-A- 2004 292 639
- US-A- 4 535 350
- US-A1- 2004 180 554

## Description

### Technical Field

The present invention relates to a precursor composition used for preparing a porous film and a method for the preparation of such a composition, a porous film prepared using the composition and a method for the preparation of the porous film, and a semiconductor device manufactured using the film. In particular, the present invention pertains to a precursor composition used for forming a hydrophobic porous film, which has a low dielectric constant and a low refractive index and which is excellent in the mechanical strength and a method for the preparation thereof; a porous film prepared using the precursor composition and a method for the preparation of such a porous film, and a semiconductor device which makes use of this porous film.

### Background Art

In the field of LSI, techniques have recently been investigated and developed widely and actively, which make use of interlayer electrical insulating films characterized in that they have a low dielectric constant (k) on the order of not more than 2.5 in addition to the use of copper electrical interconnections or copper distributing wires. There has been proposed the use, as such an interlayer electrical insulating film, of an oxide film which has been made porous to thus further reduce the dielectric constant thereof However, the use of such a porous oxide film in turn becomes a cause of, for instance, the following variety of problems: (1) the abrupt reduction of the mechanical strength of the interlayer electrical insulating film; (2) the adsorption of moisture present in the air on the interior of pores; and (3) any reduction of the adhesion between the porous film and a film adjacent to the same due to the presence of hydrophobic groups such as CH₃ groups introduced into the porous film for the solution of the foregoing problem concerning the moisture adsorption. For this reason, in the process for practically applying the porous film to semiconductor devices and, in particular, CMP (Chemical Mechanical Polishing) step in the copper dual damascene process for forming an electrical interconnection structure, in the wire-bonding process and the like, the foregoing techniques suffer from a variety of problems, for instance, (1) the breakage of the porous film due to the lowering of its mechanical strength, (2) an increase in the dielectric constant due to the moisture absorption, and (3) the occurrence of any separation of a laminated film from the porous electrical insulating film due to the reduction of the adhesion between them and this accordingly becomes a serious obstacle in putting the porous film into practical use.

Moreover, there has also been proposed, as a method for preparing an oxide having a uniform meso-fine pores, while making use of the self-organization characteristics of organic and inorganic compounds, one which comprises the step of carrying out hydrothermal synthesis in a sealed heat-resistant container while using silica gel and a surfactant (see, for instance, WO 91/11390, Pamphlet (Claims or the like)), and it has recently been reported that an oxide having such uniform meso-fine pores is prepared in the form of a film in order to use the same as a semiconductor material.

For instance, there has been known a method comprising the step of immersing a substrate in a sol consisting of a condensate of an alkoxy silane and a surfactant to make porous silica deposit on the surface of the substrate and to thus form a film thereof on the surface (see, for instance, Nature, 1996, 379: 703). Moreover, there has likewise been known another method for forming a film on a substrate, which comprises the steps of applying a solution prepared by dissolving a condensate of an alkoxy silane and a surfactant in an organic solvent onto the surface of the substrate and then evaporating the organic solvent (see, for instance, Supramolecular Science, 1998, 5: 247).

In this connection, the method for making porous silica deposit onto the surface of the substrate as disclosed in the foregoing Document (Nature, 1996, 379: 703) suffers from a variety of problems such that it takes a long period of time for the preparation of a desired product, that most of the porous silica material is deposited on the surface in its powdery form and that the yield of the product is insuffcient. Accordingly, the method comprising the step of evaporating the organic solvent, which is disclosed in the Document (Supramolecular Science, 1998, 5: 247) is rather excellent in order to prepare a porous silica film.

There has been proposed the use of, for instance, polyhydric alcohol glycol ether solvents, glycol acetate ether solvents, amido type solvents, ketone type solvents and carboxylic acid ester solvents, as the solvents usable in the method for forming a film on a substrate through the evaporation of the solvents as disclosed in the Document (Supramolecular Science, 1998, 5: 247) (see, for instance, Japanese Un-Examined Patent Publication 2000-38509 (Paragraph Nos. 0013, 0014 or the like)).

However, each of the porous films prepared according to the foregoing conventional techniques comprises a large quantity of hydrophilic moieties within the pores thereof and therefore, the film may easily take in water vapor from the surrounding air. This would become a cause of increasing the relative dielectric constant of the porous film prepared by the conventional technique. For this reason, there has been proposed, as a method for introducing hydrophobic functional groups into an interlayer electrical insulating film, for instance, one which comprises the step of subjecting silanol groups present in fine pores to trimethyl-silylation to prevent the adsorption of any moisture and to thus hold the electrical insulating characteristics of the film (see, for instance, U.S. Patent No. 6,208,014 (Claims, Abstract or the like)). Nevertheless, it has been known that this method never permits the complete trimethyl-silylation of the silanol groups present in fine pores (see, for instance, J. Phys. Chem, B1 997, No. 101 (the description appearing, for instance, on page 6525).

In addition, there has also been proposed a method for preparing a porous film free of any crack-propagation by the addition of an element of the group IA or IIA of Periodic Table (see, for instance, Japanese Un-Examined Patent Publication 2002-3784 (Claims, Paragraph No. 0004)). In this case, the concentration of the added element ranges from 0.0001 to 0.015 parts by mass per 100 parts by mass of hydrolytic condensate and the document likewise discloses that if the element is incorporated into the porous film at a concentration of more than 0.015 parts by mass, the resulting film-forming solution is insufficient in the uniform applicability According to the supplementary experiments carried out by the inventors of this invention, the use of such an element falling within the concentration range specified above would result in the formation of a porous film whose mechanical strength is insufficient and which does not have a sufficiently low dielectric constant. Thus, the method cannot provide any porous film simultaneously satisfying the requirements for a low dielectric constant and for a high mechanical strength

To ensure the simultaneous satisfaction of the foregoing two requirements for the hydrophobicity and the mechanical strength, there has been proposed a method for modifying the characteristic properties of a porous film, which comprises the steps of bringing a porous film mainly comprising Si-O bonds into close contact with a specific organic silicon atom-containing compound with heating and without using any metallic catalyst (see, for instance, Japanese Un-Examined Patent Publication 2004-292304 (Claims, Paragraph No. 0020)). However, there has practically been requested for the further improvement of the mechanical strength of the porous film.

Moreover, it has also been known to accelerate the reaction of siloxane using Pt as a catalyst (see, for instance, U.S. Patent No. 5,939,141). In this case, however, the object of this method is to improve the hydrophobicity of the heat-resistant ceramic, and essentially different from the porous film serving as an interlayer electrical insulating thin film for semiconductor which is greatly affected by the presence of impurities represented by Na or the like.

U5-2004/0180554 discloses a composition for producing a porous film as a material of reduced relative dielectric constant. The main constituents are an alkoxisilane, an alkylmethylammoniumhydroxide manufactured by electrolysis of the carbonate so that impurities, in particular metals and halogenes, are reduced, and a solvent. The composition and the resulting film has at most 10 ppm halogene and at most 100 ppb metal content.

US-4,535,350 discloses an adhesive for attaching a semiconductor die to a substrate. The adhesive composition includes a cronlinkable resinous polyimide. Optionally, metal flakes are added to render the adhesive electrically conductive.

### Disclosure of the Invention

### Problems That the Invention is to Solve

Accordingly, it is an object of the present invention to solve the foregoing problems associated with the conventional technique and more specifically to provide a precursor composition used for forming a hydrophobic porous film, which has a low dielectric constant and a low refractive index and which is excellent in the mechanical strength and a method for the preparation thereof; a porous film prepared using the precursor composition and a method for the preparation of such a porous film; and a semiconductor device which makes use of this porous film.

### Means for Solving the Problems

This object is attained by the precursor composition according to claim 1. The further claims define preferred embodiments, methods for preparing the composition, or methods for preparing a porous film using the precursor composition, a porous film obtained thereby, and a semiconductor device manufactured by the use of the porous film.

The inventors of this invention have conducted various studies to prepare a hydrophobic porous film, which has a low dielectric constant and a low refractive index and which is quite excellent in the mechanical strength, have found that the foregoing problems associated with the conventional techniques can effectively be solved by reacting a porous film with a specific hydrophobic compound through the gas-phase polymerization reaction in the presence of a specific metal and have thus completed the present invention.

Accordingly, the precursor composition of the present invention is characterized in that it comprises at least one member selected from the group consisting of compounds (A) represented by the following general formula (1):

Si(OR¹)₄ (1)

and compounds (B) represented by the following general formula (2):

Rₐ(Si)(OR²)₄₋ₐ (2)

(in the foregoing formulas (1) and (2), R¹ represents a monovalent organic group; R represents a hydrogen atom, a fluorine atom or a monovalent organic group; R² represents a monovalent organic group; a is an integer ranging from 1 to 3, provided that R, R¹ and R² may be the same or different); a heat decomposable organic compound (C) capable of being thermally decomposed at a temperature of not less than 250°C; and at least one element (D) selected from the group consisting of amphoteric elements each having an electronegativity of not more than 2.5, elements each having an ionic radius of not less than 160 pm (1.6Å) and elements each having an atomic weight of not less than 130.

When using a compound having a heat-decomposition temperature of less than 250°C as the foregoing heat decomposable organic compound (C), a problem arises such that this compound may be prematurely decomposed prior to the occurrence of the polymerization of the alkoxy-silanes represented by the foregoing general formulas (1) and (2) and that it would accordingly be quite difficult to form desired pores having a diameter as designed. Regarding the foregoing element (D), a problem likewise arises such that if the Pauling's electronegativity of an element selected and used exceeds 2.5, it would be difficult to form non-crosslinked oxygen atoms capable of promoting the reaction of an organic silicon atom-containing compound, which can mechanically strengthen the resulting porous film. In this respect, if the ionic radius of each specific element selected is not less than 160 pm (1.6Å), the element cannot migrate in SiO₂, or if the atomic weight of such an element is not less than 130, the element undergoes the piling up thereof at the interface and accordingly, never undergoes any further diffusion. Regarding the ionic radius and the atomic weight, it has been known that an alkali metal has in general very high mobility within the electrical insulating film of, for instance, SiO₂, but that it is difficult for Rb having an ionic radius of not less than 160 (1.6Å) to migrate within the electrical insulating film of, for instance, SiO₂ (Journal of Applied Physics, 56:2218). Further, it has been known that, if using an element having an atomic weight of not less than 130, the element such as Cs, whose atomic weight is 133, undergoes the piling up thereof at the interface of the film and accordingly, never undergoes any further diffusion (Applied Physics Letters, 50:1200). Therefore, the element (D) never migrates within the SiO₂ film or never undergoes any diffusion even to the exterior of the film if the element satisfies either of the requirements for the ionic radius and for the atomic weight.

The foregoing heat decomposable organic compound (C) is characterized in that it comprises at least one kind of surfactant having a molecular weight ranging from 200 to 5000. This is because if the molecular weight of the surfactant used is less than 200, the diameter of the pore capable of being formed by the method is too small, while if it exceeds 5000, the diameter of the pore formed is too large.

The precursor composition of the present invention is characterized in that the content of metallic ion impurities other than the element (D) included in the composition is not more than 10 ppb. In this respect, if the content of the metallic ion impurities exceeds 10 ppb, the presence thereof would adversely affect the reliability of the resulting semiconductor device.

The precursor composition of the present invention is likewise characterized in that the foregoing element (D) is at least one member selected from the group consisting of Al, P, Zn, Ga, Ge, As, Se, In, Sn, Sb, Te, Rb, Cs, Ba, La, Hf, Ta, W, Re, Os, Ir, Pt, Au, Hg, Tl, Pb, Bi, Po, At, and elements of the lanthanoid series.

The method for the preparation of the precursor composition for use in the formation of a porous film according to the present invention comprises the step of blending, in an organic solvent, at least one member selected from the group consisting of compounds (A) represented by the following general formula (1):

Si(OR¹)₄ (1)

and compounds (B) represented by the following general formula (2):

Rₐ(Si)(OR²)₄₋ₐ (2)

(in the foregoing formulas (1) and (2), R¹ represents a monovalent organic group; R represents a hydrogen atom, a fluorine atom or a monovalent organic group; R² represents a monovalent organic group; a is an integer ranging from 1 to 3, provided that R, R¹ and R² may be the same or different); a heat decomposable organic compound (C) capable of being thermally decomposed at a temperature of not less than 250°C; and at least one element (D) selected from the group consisting of amphoteric elements each having an electronegativity of not more than 2.5, elements each having an ionic radius of not less than 160 pm (1.6Å) and elements each having an atomic weight of not less than 130 or at least one compound containing the element (D).

In the foregoing method for the preparation of the foregoing precursor composition, it is also possible to first blend, in an organic solvent, at least one member selected from the group consisting of the compounds (A) represented by the foregoing general formula (1) and the compounds (B) represented by the foregoing general formula (2), and the foregoing heat decomposable organic compound (C); and then adding at least one of the foregoing elements (D) or at least one of the compounds containing the element (D) to the resulting mixed liquid to thus blend all of the foregoing components.

With respect to the method for the preparation of this precursor composition, the heat decomposable organic compound (C), the metallic ion impurities present in the precursor composition, and the additive elements (D) have already been discussed above in detail.

The method for preparing a porous film according to the present invention comprises the steps of forming a film on a substrate using the precursor composition for forming a porous film or the foregoing precursor composition used for the formation of a porous film, which is prepared according to the foregoing method; subjecting the resulting film to a heat-treatment at a temperature of not less than 250°C to thus make the heat decomposable organic compound contained in the precursor composition thermally decompose and to thereby form a porous film. In this respect, if the heat-treatment temperature is less than 250°C, the organic compound used in the present invention cannot satisfactorily be decomposed thermally.

The method for preparing a porous film according to the present invention further comprises the step of reacting a hydrophobic compound carrying at least one member selected from hydrophobic groups and polymerizable groups through the gas-phase reaction at a temperature ranging from 100 to 600°C in the presence of the porous film prepared by the foregoing procedures to thus modify the characteristic properties of the porous film. In this connection, the use of a reaction temperature of less than 100°C would only result in an insufficient gas-phase reaction, while the use of a reaction temperature of higher than 600°C would result in the shrinkage of the resulting porous film and the formation of a porous film having an increased relative dielectric constant.

The present invention is characterized in that the foregoing hydrophobic compound is one having at least one hydrophobic group selected form the group consisting of an alkyl group having 1 to 6 carbon atoms and a C₆H₅ group and at least one polymerizable group selected from the group consisting of hydrogen atom, OH group and a halogen atom. In this respect, if the number of carbon atoms is not less than 7, the molecular size of the resulting product would be too large and accordingly, the diffusion thereof into the pores would adversely be affected.

The present invention is characterized in that the foregoing hydrophobic compound is an organic silicon atom-containing compound having at least one bonding unit represented by the formula: Si-X-Si (in the formula, X represents an oxygen atom, an NR³ group, a -CₙH₂ₙ group, or a -C₆H₄ group, R³ represents -CₘH₂ₘ₊₁ group or a C₆H₅ group, n is an integer of 1 or 2, m is an integer ranging from 1 to 6) and at least two bonding units represented by the formula: Si-A (in the formula, A represents a hydrogen atom, a hydroxyl group, a -OC_{b}H_{2b+1} group or a halogen atom, provided that a plurality of groups A present in the same molecule may be the same or different, and b is an integer ranging from 1 to 6).

If n is not less than 3 in the foregoing hydrophobic compound, the size of the hydrophobic group is large in itself and accordingly, the compound is only insufficiently polymerized; if m is not less than 7 and b is likewise not less than 7, the resulting hydrophobic compound has a large molecular size and therefore, the diffusion thereof into the pores of the resulting porous film would be affected. In addition, the halogen atom is a fluorine, chlorine, bromine or iodine atom

The porous film of the present invention is one prepared according to the foregoing method for the preparation of the same.

The semiconductor device of the present invention is one obtained using the porous film prepared by the foregoing method for the preparation of the same.

### Effects of the Invention

The use of the precursor composition for forming a porous film according to the present invention would permit the preparation of an excellent hydrophobic porous film, which has a low dielectric constant and a low refractive index and which is likewise excellent in the mechanical strength and a desired effect such as the fabrication of a desired semiconductor device can be accomplished through the use of this porous film.

### Best Mode for Carrying Out the Invention

According to an embodiment of the present invention, the porous film having desired characteristic properties can be prepared from a solution containing a precursor composition which comprises at least one member selected from the group consisting of compounds (A) represented by the following general formula (1):

Si(OR¹)₄ (1)

and compounds (B) represented by the following general formula (2):

Rₐ(Si)(OR²)₄₋ₐ (2)

(in the foregoing formulas (1) and (2), R¹ represents a monovalent organic group; R represents a hydrogen atom, a fluorine atom or a monovalent organic group; R² represents a monovalent organic group; a is an integer ranging from 1 to 3, provided that R, R¹ and R² may be the same or different); a heat decomposable organic compound (C) containing a surfactant capable of being thermally decomposed at a temperature of not less than 250°C and having a molecular weight ranging from 200 to 5000; at least one element (D) selected from those each having a specific Pauling's electronegativity, those each having a specific ionic radius and those each having a specific atomic weight; and an organic solvent.

The foregoing solution containing the precursor composition is prepared by blending, in an organic solvent, at least one member selected from the foregoing compounds (A) and (B); the heat decomposable organic compound (C); and the predetermined element (D) or the compound containing the element (D). Alternatively, it is also possible to prepare such a solution by first blending at least one member selected from the foregoing compounds (A) and (B) and the heat decomposable organic compound (C) in an organic solvent; and then adding the predetermined element (D) or the compound containing the element (D) to the resulting mixed liquid.

An example of such a method for preparing a solution containing the precursor composition for forming the porous film will now be described below in more specifically.

A solution is prepared by blending at least one compound selected from those represented by the foregoing formulas (1) and (2), water and an organic solvent; adding, to the resulting mixture, an acidic or basic catalyst for the hydrolysis of the OR' and/or OR² present in the compound represented by the formula (1) or (2); and then stirring the resulting mixture at a temperature ranging from 20 to 80°C for 30 minutes to 5 hours for the sufficient hydrolysis of the compound represented by the formula (1) or (2). Thereafter, a surfactant is dropwise added in small portions ranging from 1 × 10⁻⁶ mole to 1 × 10⁻² mole per second while stirring the solution. At this stage, the surfactant may directly be dropwise added to the solution or it may likewise be dropwise added thereto after the dilution thereof with, for instance, an organic solvent. In this respect, the amount of the surfactant to be dropwise added to the solution per unit time may vary depending on the molecular weight of the surfactant selected, but if the amount of the surfactant is too great, the surfactant is insufficiently dispersed in the solution and the solution finally obtained would be insufficient in its uniformity. The mixing ratio of the foregoing raw materials may appropriately be determined while taking into consideration the intended relative dielectric constant of the resulting porous film.

Then the additive element (D) is added to and blended with the foregoing mixed solution. In this case, the elements (D) or the compounds containing the elements (D) may be used alone or in any combination and the method for the addition thereof and the time of the process to add the same are not restricted to particular ones. For instance, the ingredients of the solution are added or blended with one another, in order or at a time, as has been described above. Moreover, the concentration of the component to be blended is not restricted to any particular one inasmuch as it is not less than that capable of promoting the crosslinking of the silylated compound (a hydrophobic compound) during the silylation treatment and it is not higher than that capable of sufficiently ensuring the desired electrical insulating characteristics of the resulting film. For instance, the concentration thereof desirably ranges from 50 to 5000 ppm. The ultimately obtained solution is stirred at a temperature ranging from 20 to 50°C, preferably 25 to 30°C for 30 minutes to 24 hours to thus give a precursor composition-containing solution for forming a porous film.

In the present invention, the precursor composition-containing solution prepared according to the foregoing procedures is applied onto the surface of a substrate and then subjecting the substrate to a heat-treatment at a temperature of not less than 250°C to thus allow the thermal decomposition of the surfactant present in the precursor solution. Then a hydrophobic compound carrying at least one member selected from hydrophobic groups (such as an alkyl group having 1 to 6 carbon atoms, or a phenyl group) and polymerizable groups (such as a hydrogen atom, an OH group or a halogen atom) is reacted or polymerized with one another through the gas-phase reaction in the presence of the porous film thus formed and comprising the element (D). More specifically, a hydrophobic compound is introduced, in a gas-phase state, into the pores of the porous silica film to thus form a hydrophobic polymer thin film on the inner walls of the pores thereof When modifying the quality of the porous film by the formation of bonds between the inner walls of the pores and the polymer thin film, the element (D) present therein may disturb the electric neutrality of the film, this would in turn lead to the formation of non-crosslinked oxygen atoms in the porous oxide film and as a result, the gas-phase crosslinking reaction would significantly be accelerated. This element may have a function like a so-called catalytic function and accordingly, the use thereof would permit the formation of a porous film which simultaneously has a low dielectric constant and a high mechanical strength (the improvement of the elastic modulus and hardness through the reinforcement of the pore structures), to which good hydrophobicity is imparted and which has never been able to be prepared according to any conventional technique. Further, the use thereof likewise permits the promotion of the gas-phase polymerization reaction and therefore, this would result in the reduction of the heat-treatment temperature throughout the entire process. More specifically, when the present invention is applied to the formation of the interlayer electrical insulating film of a semiconductor device which has increasingly been finer and finer, an electrical insulating film having a sufficiently high mechanical strength can be prepared even when the heat-treatment currently carried out at 400°C is replaced with a low temperature firing treatment at a temperature of not more than 350°C.

The following are the detailed description of each component used in the foregoing precursor composition and porous film:

### (Alkoxy-silanes)

In the compounds (A) and (B) represented by the foregoing general formulas (1) and (2) respectively, the monovalent organic group represented by R, R¹ and R² includes, for instance, an alkyl group, an aryl group, an allyl group and a glycidyl group.

The monovalent organic group represented by R¹ appearing in Formula (1) may be, for instance, an alkyl group or an aryl group. As such alkyl groups, preferably used herein include, for instance, those having 1 to 5 carbon atoms and specific examples thereof are methyl, ethyl, propyl and butyl groups. Each of these alkyl groups may be a linear or branched one and one or some of the hydrogen atoms thereof may be substituted with a substituent (or substituents) such as a fluorine atom The aryl group may be, for instance, a phenyl group, a naphthyl group, a methyl-phenyl group, an ethyl-phenyl group, a chlorophenyl group, a bromophenyl group, and a fluoro-phenyl group. Preferably used herein as the monovalent organic groups represented by R¹ are alkyl and phenyl groups. In addition, as the monovalent organic groups represented by R and R² appearing in Formula (2), there may be listed, for instance, those described above in connection with the R¹ appearing in Formula (1).

The alkoxy-silanes represented by the foregoing general formulas (1) and (2) and usable in the present invention are not restricted to particular ones and specific examples thereof are as follows:
For instance, quaternary alkoxy silanes such as tetramethoxy silane, tetraethoxy silane, tetra-isopropoxy silane and tetrabutyl silane; and tertiary alkoxy silanes such as trimethoxy fluorosilane, triethoxy fluorosilane, tri-isopropoxy fluorosilane, and tributoxy fluorosilane;
· Fluorine atom-containing alkoxy silanes such as CF₃(CF₂)₃CH₂CH₂Si(OCH₃)₃, CF₃(CF₂)₅ CH₂CH₂Si(OCH₃)₃, CF₃(CF₂)₇CH₂CH₂Si(OCH₃)₃, CF₃(CF₂)₉CH₂CH₂Si(OCH₃)₃, (CF₃)₂ CF(CF₂)₄ CH₂CH₂Si(OCH₃)₃, (CF₃)₂CF(CF₂)₆CH₂CH₂Si(OCH₃)₃, (CF₃)₂CF(CF₂)₈CH₂CH₂ Si(OCH₃)₃, CF₃(C₆H₄)CH₂CH₂Si(OCH₃)₃, CF₃(CF₂)₃(C₆H₄)CH₂CH₂Si(OCH₃)₃, CF₃(CF₂)₅ (C₆H₄)CH₂CH₂Si(OCH₃)₃, CF₃(CF₂)₇(C₆H₄)CH₂CH₂Si(OCH₃)₃, CF₃(CF₂)₃CH₂CH₂ SiCH₃ (OCH₃)₂, CF₃(CF₂)₅CH₂CH₂SiCH₃(OCH₃)₂, CF₃(CF₂)₇CH₂CH₂SiCH₃(OCH₃)₂, CF₃(CF₂)₉ CH₂CH₂SiCH₃(OCH₃)₂, (CF₃)₂CF(CF₂)₄CH₂CH₂SiCH₃(OCH₃)₂, (CF₃)₂CF(CF₂)₆CH₂CH₂ SiCH₃(OCH₃)₂, (CF₃)₂CF(CF₂)₈CH₂CH₂SiCH₃(OCH₃)₂, CF₃(C₆H₄)CH₂CH₂SiCH₃(O-CH₃)₂, CF₃(CF₂)₃(C₆H₄)CH₂CH₂SiCH₃(OCH₃)₂, CF₃(CF₂)₅(C₆H₄)CH₂CH₂SiCH₃(OCH₃)₂, CF₃(CF₂)₇(C₆H₄)CH₂CH₂SiCH₃(OCH₃)₂, CF₃(CF₂)₃CH₂CH₂Si(OCH₂CH₃)₃, CF₃(CF₂)₅ CH₂CH₂Si(OCH2CH₃)₃, CF₃(CF₂)₇CH₂CH₂Si(OCH₂CH₃)₃, and CF₃(CF₂)₉CH₂CH₂Si(O-CH₂CH₃)₃;
· Tertiary alkoxyalkyl silanes such as trimethoxy methyl silane, triethoxy methyl silane, trimethoxy ethyl silane, triethoxy ethyl silane, trimethoxy propyl silane and triethoxy propyl silane;

· Tertiary alkoxyaryl silanes such as trimethoxy phenyl silane, triethoxy phenyl silane, trimethoxy chlorophenyl silane, and triethoxy chlorophenyl silane;
· Tertiary alkoxy-phenethyl silanes such as trimethoxy phenethyl silane, and triethoxy phenethyl silane; and
· Secondary alkoxyalkyl silanes such as dimethoxy dimethyl silane, and diethoxy dimethyl silane.

In the present invention, the foregoing alkoxy silanes may be used alone or in any combination of at least two of them.

### (Organic Solvent)

Examples of organic solvents usable in the present invention include mono-alcoholic solvents such as methanol, ethanol, n-propanol, i-propanol n-butanol, i-butanol, sec-butanol, t-butanol, n-pentanol, i-pentanol, 2-methyl butanol, sec-pentanol, t-pentanol, 3-methoxy butanol, n-hexanol, 2-methyl pentanol, sec-hexanol, 2-ethyl butanol, sec-heptanol, heptanol-3, n-octanol, 2-ethyl hexanol, sec-octanot, n-nonyl alcohol, 2,6-dimethyl heptanol-4, n-decanol, sec-undecyl alcohol, trimethyl nonyl alcohol, sec-tetradecyl alcohol, sec-heptadecyl alcohol, phenol, cyclohexanol, methyl cyclohexanol, 3,3,5-trimethyl cyclohexanol, benzyl alcohol, phenylmethyl carbinol, diacetone alcohol and cresol;

Polyhydric alcoholic solvents such as ethylene glycol, 1,2-propylene glycol, 1,3-butylene glycol, pentanediol-2,4, 2-methyl pentane-diol-2,4, hexanediol-2,5, heptane-diol-2,4, 2-ethyl hexanediol-1,3, diethylene glycol, di-propylene glycol, triethylene glycol, tri-propylene glycol, and glycerin;

Ketone type solvent such as acetone, methyl ethyl ketone, methyl-n-propyl ketone, methyl-n-butyl ketone, diethyl ketone, methyl-i-butyl ketone, methyl-n-pentyl ketone, ethyl-n-butyl ketone, methyl-n-hexyl ketone, di-i-butyl ketone, trimethyl nonanone, cyclohexanone, 2-hexanone, methyl cyclohexanone, 2,4-pentane-dione, acetonyl acetone, diacetone alcohol, acetophenone, and fenthion;

Ether type solvents such as ethyl ether, i-propyl ether, n-butyl ether, n-hexyl ether, 2-ethylhexyl ether, ethylene oxide, 1,2-propylene oxide, dioxolan, 4-methyl-dioxolan, dioxane, dimethyl dioxane, ethylene glycol monomethyl ether, ethylene glycol monoethyl ether, ethylene glycol diethyl ether, ethylene glycol mono-n-butyl ether, ethylene glycol mono-n-hexyl ether, ethylene glycol mono-phenyl ether, ethylene glycol mono-2-ethyl-butyl ether, ethylene glycol dibutyl ether, diethylene glycol mono-methyl ether, diethylene glycol mono-ethyl ether, diethylene glycol diethyl ether, diethylene glycol mono-n-butyl ether, diethylene glycol di-n-butyl ether, diethylene glycol mono-n-hexyl ether, ethoxy triglycol, tetraethylene glycol di-n-butyl ether, propylene glycol mono-methyl ether, propylene glycol mono-ethyl ether, propylene glycol mono-propyl ether, propylene glycol mono-butyl ether, di-propylene glycol mono-methyl ether, di-propylene glycol mono-ethyl ether, tri-propylene glycol mono-methyl ether, tetra-hydrofuran, and 2-methyl tetrahydrofuran;

Ester type solvents such as diethyl carbonate, methyl acetate, ethyl acetate, γ *-* butyrolactone, γ -valerolactone, n-propyl acetate, i-propyl acetate, n-butyl acetate, butyl acetate, sec-butyl acetate, n-pentyl acetate, sec-pentyl acetate, 3-methoxybutyl acetate, methyl-pentyl acetate, 2-ethylbutyl acetate, 2-ethylhexyl acetate, benzyl acetate, cyclohexyl acetate, methyl cyclohexyl acetate, n-nonyl acetate, methyl acetoacetate, ethyl acetoacetate, ethylene glycol mono-methyl ether acetate, ethylene glycol mono-ethyl ether acetate, diethylene glycol mono-methyl ether acetate, diethylene glycol mono-ethyl ether acetate, diethylene glycol mono-n-butyl ether acetate, propylene glycol mono-methyl ether acetate, propylene glycol mono-ethyl ether acetate, propylene glycol mono-propyl ether acetate, propylene glycol mono-butyl ether acetate, dipropylene glycol mono-methyl ether acetate, dipropylene glycol mono-ethyl ether acetate, glycol diacetate, methoxy-triglycol acetate, ethyl propionate, n-butyl propionate, i-amyl propionate, diethyl oxalate, di-n-butyl oxalate, methyl lactate, ethyl lactate, n-butyl lactate, n-amyl lactate, diethyl malonate, dimethyl phthalate, and diethyl phthalate; and

Nitrogen atom-containing solvents such as N-methyl formamide, N,N-dimethyl formamide, N,N-diethyl formamide, acetamide, N-methyl acetamide, N,N-dimethyl acetamide, N-methyl propionamide, and N-methyl pyrrolidone.

In the present invention, the foregoing organic solvents can be used alone or in any combination of at least two of them.

### (Acidic and Basic Catalysts)

The catalyst usable in the solution of the precursor composition according to the present invention comprises at least one kind of acidic or basic catalyst.

Examples of such acidic catalysts are inorganic acids and organic acids.

Specific examples of inorganic acids usable herein include hydrochloric acid, nitric acid, sulfuric acid, hydrofluoric acid, phosphoric acid, boric acid, and hydrobromic acid.

Specific examples of organic acids are acetic acid, propionic acid, butanoic acid, pentanoic acid, hexanoic acid, heptanoic acid, octanoic acid, nonanoic acid, decanoic acid, oxalic acid, maleic acid, methyl malonic acid, adipic acid, sebacic acid, gallic acid, butyric acid, mellitic acid, arachidic acid, shikimic acid, 2-ethyl hexanoic acid, oleic acid, stearic acid, linolic acid, linolenic acid, salicylic acid, benzoic acid, p-amino-benzoic acid, p-toluene-sulfonic acid, benzene-sulfonic acid, monochloro-acetic acid, dichloroacetic acid, trichloroacetic acid, trifluoroacetic acid, formic acid, malonic acid, sulfonic acid, phthalic acid, fumaric acid, citric acid, tartaric acid, succinic acid, itaconic acid, mesaconic acid, citraconic acid, and malic acid.

As the foregoing basic catalysts, there may be listed, for instance, ammonium salts and nitrogen atom-containing compounds.

Specific examples of such ammonium salts are tetramethyl ammonium hydroxide, tetraethyl ammonium hydroxide, tetra-propyl ammonium hydroxide, and tetra-butyl ammonium hydroxide.

Specific examples of nitrogen atom-containing compounds include pyridine, pyrrole, piperidine, 1-methyl-piperidine, 2-methyl-piperidine, 3-methyl-piperidine, 4-methyl-piperidine, piperazine, 1-methyl-piperazine, 2-methyl-piperazine, 1,4-dimethyl-piperazine, pyrrolidine, 1-methyl-pyrrolidine, picoline, monoethanol-amine, diethanol-amine, dimethyl monoethanol-amine, monomethyl diethanol-amine, triethanol-amine, diaza-bicyclo-octene, diaza-bicyclononane, diaza-bicyclo-undecene, 2-pyrazoline, 3-pyrroline, quinuclidine, ammonia, methylamine, ethylamine, propylamine, butylamine, N,N-dimethyl-amine, N,N- diethyl-amine, N,N-dipropyl-amine, N,N-dibutyl-amine, trimethyl-amine, triethyl-amine, tripropyl-amine, and tributyl-amine.

Furthermore, all of the acidic/basic compounds containing the additive elements (D) used in the present invention may likewise be used as the foregoing catalysts.

### (Surfactants)

Regarding the surfactants usable in the solution of the precursor composition according to the present invention, the molecular weight thereof is not restricted to specific one. However, if it has a low molecular weight, the resulting porous film includes pores having a small size and this accordingly leads to the insufficient penetration of the intended reactants into the pores in the gas-phase reaction after the formation of such pores, while if the surfactant used has a high molecular weight, the resulting porous film includes pores whose size is too great. Accordingly, the surfactant used herein preferably has a molecular weight ranging from 200 to 5000. Preferred examples thereof are those listed below:
(I) Compounds each carrying a long chain alkyl group and a hydrophilic group: In this respect, the long chain alkyl group is preferably one having 8 to 24 carbon atoms and more preferably one having 12 to 18 carbon atoms. On the other hand, the hydrophilic group may be, for instance, a quaternary ammonium residue, an amino group, a nitroso group, a hydroxyl group or a carboxyl group, with a quaternary ammonium residue or a hydroxyl group being quite desirably used herein. Specific examples of such surfactants preferably used herein are alkyl-ammonium salts represented by the following general formula:

   CₙH₂ₙ₊₁(N(CH₃)₂(CH₂)ₘ)ₐ(CH₂)_{b}N(CH₃)₂C_{L}H_{2L+1}X₍₁₊ₐ₎

   (In the foregoing general formula, a is an integer ranging from 0 to 2; b is an integer ranging from 0 to 4; n is an integer ranging from 8 to 24; m is an integer ranging from 0 to 12; L is an integer ranging from 1 to 24; and X represents a halide ion, HSO₄⁻ or a monovalent organic anion). In this respect, if each of the suffixes a, b, n, m, and L falls within the range specified above and X represents such an ion, the resulting porous film has pores having a predetermined size and intended reactants are sufficiently penetrated into the pores in the gas-phase reaction after the formation of such pores to thus induce an intended polymerization reaction.
(II) Compounds having polyalkylene oxide structures: In this respect, examples of such polyalkylene oxide structures include polyethylene oxide structures, polypropylene oxide structures, polytetramethylene oxide structures, and polybutylene oxide structures. Specific examples of the compounds having such polyalkylene oxide structures include ether type compounds such as polyoxyethylene polyoxypropylene block copolymers, polyoxyethylene polyoxybutylene block copolymers, polyoxyethylene polyoxypropylene alkyl ether, polyoxyethylene alkyl ether, polyoxyethylene alkylphenyl ether; and ether-ester type compounds such as polyoxyethylene glycerin fatty acid esters, polyoxyethylene sorbitan fatty acid esters, polyethylene sorbitol fatty acid esters, sorbitan fatty acid esters, propylene glycol fatty acid esters, and sucrose fatty acid esters.

In the present invention, the foregoing surfactants may be used alone or in any combination of at least two of them.

### (Additive Element)

Regarding the additive element (D) used in the present invention, it is quite important that it can increase the number of the non-crosslinked oxygen atoms within the SiO₂ from such a viewpoint of promoting the gas-phase polymerization reaction, as mentioned above. When it is intended to promote the gas-phase polymerization reaction by increasing the number of non-crosslinked oxygen atoms in the Si-O as the basic skeleton of the porous film, elements having a Pauling's electronegativity of higher than 1.8, which corresponds to the electronegativity of Si (in this respect, for instance, oxygen and carbon have Pauling's electronegativity values of 3.5 and 2.5, respectively) are not suitable for the achievement of the intended purpose of the present invention so as to promote the gas-phase polymerization reaction (due to the catalytic action of the metal elements), while increasing the number of non-crosslinked oxygen atoms through the formation of ionic bond with the skeletal Si atoms of the porous film since the elements having an electronegativity of higher than those of Si, oxygen, carbon atoms tend to form covalent bonds in the porous film comprising Si-O bonds or further optionally Si-C bonds. Furthermore, in this regard, the metallic element to be incorporated into the porous film should have desired characteristic properties such that it can stably remain in the film even when any stress, in particular, an electrical stress is applied to the porous film, or that it never adversely affects any component other than the porous film in, for instance, the object such as a semiconductor device to which the porous film is applied. If the element included in this case is the usual metallic element, it would adversely affect the quality of the semiconductor in itself and accordingly, the use thereof is not suitable. However, the elements which are metallic and amphoteric elements such as Al, Zn, Sn, Pb or the like never adversely affect the characteristic properties of the semiconductor and there have already been known some instances in which they are used in semiconductors. Alternatively, metallic elements may be used without any restriction or trouble inasmuch as they are elements each having an ionic radius of not less than 160 pm (1.6Å), which can hardly migrate in the porous film even when an electrical stress is applied to the film to some extent, or elements having an atomic weight of not less than 130 and more specifically, heavy elements belonging to the 6^{th} period in Periodic Table (elements having an atomic number of not less than 55).

Typical elements (D) which can fulfill the foregoing requirements for the characteristic properties and which can be used in the present invention include, for instance, B, Al, P, Zn, Ga, Ge, As, Se, In, Sn, Sb, Te, Rb, Cs, Ba, La, Hf, Ta, W, Re, Os, Ir, Pt, Au, Hg, Tl, Pb, Bi, Po, At, and elements of the lanthanoid series. Preferably used herein include, for instance, at least one member selected from the group consisting of Cs, Ba, elements of the lanthanoid series, Hf, P, Pb, Bi, Po, Se, Te, As, Rb, Al, and Sn. In this respect, it is sufficient that the precursor composition for forming a porous film comprises at least one of these elements.

The method for the incorporation of the foregoing additive elements into the porous film is not restricted to any specific one and it can be incorporated into the same by, for instance, a method in which the element per se is introduced into the film, or it is introduced into the same in the form of a compound containing the intended element. Such an intended element-containing compound is not restricted to any particular one, and may be, for instance, nitrate compounds, oxide compounds, organo-metallic compounds, basic compounds and any known compound which permits the formation of the metallic element used in the present invention and thus, each desired element can be introduced into the porous film using such a compound. At this stage, these compounds are preferably introduced into the precursor composition-containing solution for forming the porous film in the form of a mixture with water and/or an organic solvent such as an alcohol.

It is sufficient that the additive element is used in a catalytic concentration, but it is preferably used in an amount ranging from 50 to 5000 ppm on the basis of the amount of the precursor composition-containing solution, as will be clear from the results obtained in Example 2 described later.

### (Hydrophobic Compound)

The hydrophobic compound usable in the present invention is preferably one having at least one hydrophobic group consisting of an alkyl group having I to 6 carbon atoms or a C₆H₅ group and at least one polymerizable group consisting of hydrogen atom and OH group or a halogen atom In this respect, the alkyl group may be, for instance, methyl, ethyl, propyl, and butyl groups, which may be linear or branched ones and whose hydrogen atom(s) may be substituted with a halogen atom or the like. Examples of such halogen atoms are fluorine, chlorine, bromine and iodine atoms.

Specific examples of such hydrophobic compounds include 1,2-bis(tetramethyl-di-siloxanyl)ethane, 1,3-bis(trimethyl-siloxy)-1,3-dimethyl disiloxane, 1,1,3,3-tetraisopropyl disiloxane, 1,1,3,3-tetraphenyl disiloxane, 1,1,3,3-tetraethyl disiloxane, 1,1,4,4-tetramethyl disiloxane, 1,1,3,3,5,5-hexamethyl trisiloxane, 1,1,3,3,5,5-hexaisopropyl tri-siloxane, 1,1,3,3,5, 5,7,7-octamethyl tetrasiloxane, 1,1,1,3,5,5-hexamethyl trisiloxane, 1,1,1,3,3,5,7,7-octamethyl tetrasiloxane, 1,3-dimethyl-tetramethoxy disiloxane, 1,1,3,3-tetramethyl-,3-diethoxy disiloxane, 1,1,3,3,5,5-hexamethyl diethoxy trisiloxane, tetramethyl-1,3-dimethoxy disiloxane.

Alternatively, the hydrophobic compound which can be used in the present invention is an organic silicon atom-containing compound having at least one bonding unit represented by the formula: Si-X-Si (in the formula, X represents an oxygen atom, an NR³ group, a -CₙH₂ₙ group, or a -C₆H₄group, R³ represents -CₘH₂ₘ₊₁ group or a -C₆H₅ group, n is an integer of 1 or 2, m is an integer ranging from 1 to 6) and at least two bonding units represented by the formula: Si-A (in the formula, A represents a hydrogen atom, a hydroxyl group, a -OC_{b}H_{2b+1} group or a halogen atom, provided that a plurality of groups A present in the same molecule may be the same or different, and b is an integer ranging from 1 to 6). Specific examples of the organic silicon atom-containing compound are 1,2,3,4,5,6-hexamethyl-cyclotrisilazane, 1,3,5,7-tetraethyl-2,4,6,8-tetramethyl-cyclotetrasilazane, 1,2,3-triethyl-2,4,6-triethyl-cyclotrisilazane.

According to the present invention, it is also possible to use a cyclic siloxane as such a hydrophobic compound. The cyclic siloxanes usable herein may preferably be at least one member selected from the group consisting of those represented by, for instance, the following general formula: 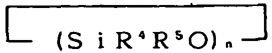 (In the general formula, R⁴ and R⁵ may be the same or different and each represents a hydrogen atom, a -C₆H₅ group, a -C_{c}H_{2c+1} group, a CF₃(CF₂)_{d}(CH₂)ₑ group, or a halogen atom, c is an integer ranging from 1 to 3, d is an integer ranging from 0 to 10, e is an integer ranging from 0 to 4, and n is an integer ranging from 3 to 8).

The cyclic siloxane compound represented by the foregoing general formula is preferably one having two or more Si-H bonds in the molecule, and it is also preferred that either one of or the both of the substituents R⁴ and R⁵ are hydrogen atoms.

The use of such a cyclic siloxane would permit the formation of a porous silica film having an increased hydrophobicity and therefore, the resulting porous silica film accordingly has a reduced dielectric constant.

Specific examples of such cyclic siloxanes are tri(3,3,3-trifluoro-propyl)-trimethyl cyclotrisiloxane, triphenyl-trimethyl cyclotrisiloxane, 1,3,5,7-tetramethyl cyclo-tetra-siloxane, octamethyl cyclo-tetra-siloxane, 1,3,5,7-tetramethyl-1,3,5,7-tetraphenyl cyclo-tetra-siloxane, 1,3,5,7-tetraethyl cyclotetrasiloxane and pentamethyl cyclo-pentasiloxane. The cyclic siloxanes usable in the present invention may be at least one member selected from the group consisting of those listed above. Among the foregoing cyclic siloxanes, preferably used in the present invention is 1,3,5,7-tetramethyl cyclo-tetrasiloxane.

In addition, the cyclic siloxanes usable herein may likewise be at least one member selected from the group consisting of those represented by the following general formula: 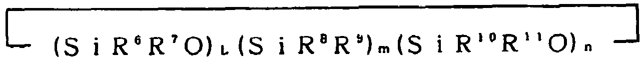 (In the general formula, R⁶, R⁷, R⁸, R⁹, R¹⁰ and R¹¹ may be the same or different and each represents a hydrogen atom, a -C₆H₅ group, a -C_{f}H_{2f+1} group, a CF₃(CF₂)_{g}(CH₂)ₕ group, or a halogen atom, f is an integer ranging from 1 to 3, g is an integer ranging from 0 to 10, h is an integer ranging from 0 to 4, L is an integer ranging from 0 to 8, m is an integer ranging from 0 to 8 and n is an integer ranging from 0 to 8, provided that these L, m and n satisfy the following relation: 3≦L+m+n≦8, and that the compound comprises at least two Si-H bonds). Specific examples thereof are 1,2,3,4,5,6-hexamethyl cyclotrisiloxane, 1,3,5,7-tetraethyl-2,4,6,8-tetramethyl cyclotetrasiloxane, and 1,2,3-triethyl-2,4,6-triethyl cyclotrisiloxane.

Furthermore, the cyclic siloxanes usable herein, in which either of R⁴ and R⁵ is hydrogen, may likewise be at least one member selected from the group consisting of those represented by, for instance, the following general formula: 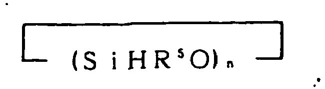 (In the general formula, R⁵ is the same as that specified above). As has already described above, specific examples thereof are 1,3,5,7-tetramethyl cyclo-tetrasiloxane, 1,3,5,7-tetraethyl cyclotetrasiloxane, 1,3,5,7-tetraphenyl cyclo-tetrasiloxane, and pentamethyl cyclo-pentasiloxane. These cyclic siloxanes may be used alone or in any combination of two or more of them.

It is sufficient that the foregoing hydrophobic compound is used in an amount which permits the formation of a polymer thin film on the inner walls of pores present in the porous silica film as a raw material and the hydrophobic compound is desirably used in an amount of, for instance, not less than 0.1% by volume on the basis of the total gas volume used in the gas-phase reaction.

The foregoing substrate used is not restricted to any particular one, and usable herein include, for instance, glass, quartz, silicon wafer, and stainless steel. The shape thereof is not likewise restricted to any particular one, and it may be either a plate-like one or a dish-like one.

In the foregoing description, the method for the application of the precursor composition- containing solution for forming a porous film onto the surface of a substrate is not limited to any specific one and specific examples thereof are those commonly used in this field such as spin-coating techniques, cast-coating techniques, and dip-coating techniques. In the case of the spin-coating technique, a substrate is placed on a spinner and a coating solution is dropwise added to the surface of the substrate, while rotating the substrate at a rate ranging from 500 to 10,000 rpm.

The present invention permits the formation of a porous silica film excellent in the dielectric constant, hydrophobicity or the like, and accordingly, it is not needed to carry out any treatment for making the modified porous silica film hydrophobic after the preparation of the modified silica film.

Moreover, the porous silica film obtained after the gas-phase reaction may still have un-polymerized residues of the hydrophobic compound and when laminating the resulting quality-modified porous silica film with another film, applied onto the porous film, such as a metal thin film or an electrical insulating layer, the adhesion between these films would be improved due to the presence of such un-polymerized residues of the hydrophobic compound.

Furthermore, according to the present invention, the reaction chamber is first evacuated to a desired reduced pressure prior to the introduction of the vapor of a hydrophobic compound into the reaction chamber, then the vapor of the hydrophobic compound is introduced into the chamber, while maintaining the internal pressure of the reaction chamber to thus moderately polymerize the hydrophobic compound. The diffusibility of the vapor of the hydrophobic compound within the reaction chamber is considerably improved and the concentration thereof within pores present in the porous film is accordingly set at a uniform level.

In addition, according to the foregoing method, the gaseous molecules of the hydrophobic compound can be introduced into the reaction chamber after the preliminary removal of, for instance, gas molecules and water molecules present in the pores of the porous film and the polymerization reaction can thus be carried out under a reduced pressure. For this reason, the compound can be penetrated into the pores of the film with excellent diffusibility. As a result, the method permits the uniform diffusion of this hydrophobic compound into the pores of the film within a very short period of time to thus initiate the polymerization thereof and accordingly, the present invention permits the solution of the problem concerning the uniformity of the processing effect, which is encountered when handling a porous silica film having a large area.

As has been discussed above, the quality-modified porous silica film of the present invention is excellent in the both dielectric constant and hydrophobicity and likewise excellent in the mechanical strength as well and therefore, the porous silica film can be used as a semiconductor material for forming an interlayer electrical insulating film and an electrical insulating film arranged between electrical interconnections; an optical functional material such as a molecular recording medium, a transparent conductive film, a solid electrolyte, an optical waveguide and a color part for LCD; and an electronic functional material. In particular, it has been required for the interlayer electrical insulating films or the electrical insulating films arranged between electrical interconnections as the semiconductor materials that they should have a low dielectric constant and a high mechanical strength and should be hydrophobic in nature and accordingly, it is preferred to use the modified porous silica film according to the present invention having the low dielectric constant and the excellent hydrophobicity and the mechanical strength, as the semiconductor material.

A semiconductor device will now be described in more specifically, which makes use of the quality-modified porous silica film of the present invention as the electrical insulating film arranged between electrical interconnections (hereunder referred to as "inter-layer insulating film").

First of all, a quality-modified porous silica film is formed on the surface of a substrate according to the procedures described above. The modified porous silica film-forming method of the present invention permits the formation of an inter-layer insulating film having a low dielectric constant and a high mechanical strength and the excellent hydrophobicity. Then a hard mask and a photoresist layer are formed on the modified porous silica film to thus etch the silica film in the pattern corresponding to that formed on the photoresist layer. After the completion of the etching, a barrier layer consisting of, for instance, titanium nitride (TiN) or tantalum nitride (TaN) is formed on the surface of the porous silica film according to the chemical vapor deposition (CVD) technique or the vapor phase growth technique.

After the formation of the barrier film on the surface of the porous silica film according to the present invention, a copper electrical interconnection layer is formed according to the metal CVD technique, the sputtering technique or the electrolytic plating technique and then the resulting film is made smooth by the CMP technique. Then a capping film is formed on the film surface. Moreover, a hard mask is, if necessary, formed and the foregoing steps may be repeated to give a multi-layered structure and to thus form a semiconductor device of the present invention.

In the foregoing description, an electrical insulating film material for a semiconductor circuit element is taken by way of a preferred example, but the present invention is not restricted to such a specific example at all and accordingly, the present invention can likewise be applied to, for instance, waterproofing films as electric materials which require a surface processing carried out in an aqueous solution, catalytic materials and filter materials.

The present invention will now be described in more detail with reference to the following Examples. The following are the ingredients of a precursor composition-containing solution for forming a porous film as well as the measuring devices used in the following Examples:
Alkoxy-silanes: Tetraethoxy silane, dimethyl diethoxy-silane (Electronic-Industrial Grade available from YAMANAKA Semiconductors Co., Ltd);
H₂O: Pure water subjected to a de-mineralization treatment and having a resistance value of 18 MΩ;
Organic solvent: Ethanol (Electronic-Industrial Grade available from WAKO Pure Chemical Co., Ltd.);
Surfactant: A product obtained by dissolving poly(alkylene oxide) block copolymer, HO(CH₂CH₂O)₁₃(CH₂CH(CH))O)₂₀(CH₂CH₂O)₁₃H (trade name: EPAN available from Dai-Ichi Kogyo Seiyaku Co., Ltd.) in the foregoing ethanol of the electronic-industrial grade and then subjected to a de-mineralization treatment;
Additive element or element-containing compound: One available from Highly Pure Chemical Research Laboratory;
Silylating Agent: 1,3,5,7-Tetramethyl cyclotetrasiloxane (Electronic-Industrial Grade available from TRICHEMICAL Co., Ltd.);
Film-Thickness, Refractive Index: This was determined using Spectro-ellipsometry (GES5 available from SOPRA Company);
Dielectric Constant: This was determined using a mercury-probe measuring method (SSM2000 available from SSM Company); and
Mechanical Strength: This was determined using a nano-indentater (Nano Indenter DCM available from MTS Systems Corporation).

### Example 1

To ethanol solvent, there were added 0.48 mole of tetraethoxy silane (TEOS), 1.6 mole of H₂O, 0.0071 mole of dimethyl-diethoxy silane (DMDEOS), 0.1 mole of a nonionic surfactant (trade name: P45; average molecular weight: 2300; HO(CH₂CH₂O)₁₃(CH(CH₃)CH₂O)₂₀ (CH₂CH₂O)₁₃H) in an acidic environment (nitric acid: 0.06 mole), followed by stirring the resulting mixture at 25°C for 24 hours to thus give a transparent and uniform coating solution. In this regard, the amount of the DMDEOS is not restricted to any specific level, but if this substance is not used, the porous silica film obtained after the firing operation shows X-ray diffraction peaks which are attributable to the presence of the two-dimensional hexagonal pore-arrangement and accordingly, it would be quite difficult to obtain a porous film having Worm-Hole-like pore structure.

The coating solution thus obtained was applied onto the surface of a semiconductor Si substrate according to the spin-coating technique, which was carried out at a rotational speed of 1,200 rpm. Thereafter, the substrate thus treated was subjected to a firing treatment at 400°C for one hour in the air to thus obtain a raw porous silica film. The time required for raising the firing temperature up to 400°C was found to be 15 minutes. At this stage, the temperature, the time required for raising the temperature and the time for maintaining the temperature at that level were not restricted to specific ones. It is accordingly sufficient that they are appropriately set at levels which never adversely affect the quality of the resulting porous film.

After the preparation of the porous silica film according to the foregoing method, the film was fired at 400°C and a pressure of 90 kPa for 30 minutes, within a gaseous atmosphere of 1,3,5,7-tetramethyl-cyclotetrasiloxane (TMCTS) to thus form a porous silica film having a high hydrophobicity and a low dielectric constant. In this case, the vapor of TMCTS was introduced into the firing oven together with an inert gas of N₂ serving as a carrier gas and the mixed gas was always passed through the oven throughout the firing operation. At this stage, it was found that the inner walls of the pores present in the porous silica film thus prepared were covered with a polymethyl siloxane film as a hydrophobic polymer thin film. At this stage, the resulting porous film was inspected for a variety of properties and as a result, the film was found to have a relative dielectric constant (k) of 2.147, a refractive index of 1.1844, an elastic modulus of 3.988 GPa and a hardness of 0.45 GPa.

### Example 2

The same procedures (and coating and firing conditions) used in Example 1 were repeated except for using a solution prepared by adding a Cs(NO₃)/H₂O mixture to the coating solution used in Example 1 in such an amount that the content of Cs element fell within the range of from 0.01 to 5000 ppm to thus give a Cs-containing porous film, followed by subjecting the resulting porous film to the TMCTS treatment similar to that used in Example 1 to thus give a porous silica film.

Physical properties of the film obtained in this Example are listed in the following Table 1:

**Table 1:**

| Cs Conc. (ppm) | Refractive Index | Relative Dielectric Const. (k) | Elastic Modulus (GPa) | Hardness (GPa) |
|---|---|---|---|---|
| 0.01 | 1.18447 | 2.15 | 3.99 | 0.45 |
| 1.0 | 1.22295 | 2.09 | 5.44 | 0.68 |
| 10 | 1.23274 | 2.02 | 5.79 | 0.74 |
| 50 | 1.21772 | 2.08 | 5.72 | 0.67 |
| 100 | 1.23136 | 2.03 | 6.10 | 0.85 |
| 500 | 1.23730 | 2.03 | 7.17 | 1.01 |
| 5000 | 1.25334 | 2.21 | 8.79 | 1.48 |

The data listed in Table 1 clearly indicate that the refractive index, elastic modulus and hardness of the porous film monotonously increase as the content of the metal element increases, but the relative dielectric constant thereof is once reduced and then increases when the metal concentration exceeds 5000 ppm since the amount of TMCTS adhered is too high These facts clearly indicate that when adding a metal element to the porous silica film, the content thereof should be limited to a level of not more than 5000 ppm. While if the content of the metal element is 0.01 ppm, the resulting porous film has a low relative dielectric constant, but it has likewise low elastic modulus and hardness and accordingly, the concentration of the metal element is in general not less than 0.1 ppm, preferably not less than 1 ppm and not more than 5000 ppm, while taking into consideration the elastic modulus and hardness of the resulting film.

The results obtained in Example 2 show that the refractive index, elastic modulus and hardness serve as important indicators for the evaluation of the effect of the additive element to accelerate or promote the crosslinking of TMCTS in the treatment with the same, while the relative dielectric constant never serves as a correct indicator for the crosslinking-acceleration effect. For this reason, the resulting porous film will mainly be inspected for the refractive index, elastic modulus and hardness in each of the following Examples including Example 3. In every Example, there were observed significant improvement in the refractive index, elastic modulus and hardness due to the acceleration of the crosslinking of TMCTS by the incorporation of the additive element.

### Example 3

The same procedures (and coating and firing conditions) used in Example 1 were repeated except for using a solution prepared by adding a P₂O₅/EtOH mixture to the coating solution used in Example 1 in such an amount that the content of elemental P was equal to 1000 ppm to thus give a P-containing porous film, followed by subjecting the resulting porous film to the TMCTS treatment similar to that used in Example 1 to thus give a porous silica film. At this stage, the resulting porous film was inspected for a variety of properties and as a result, the film was found to have a refractive index of 1.2680, a relative dielectric constant of 3.00, an elastic modulus of 9.37 GPa and a hardness of 0.97 GPa.

### Example 4

The same procedures (and coating and firing conditions) used in Example 1 were repeated except for using a solution prepared by adding a Ba(NO₃)₂/H₂O mixture to the coating solution used in Example 1 in such an amount that the content of elemental Ba was equal to 1000 ppm to thus give a Ba-containing porous film, followed by subjecting the resulting porous film to the TMCTS treatment similar to that used in Example 1 to thus give a porous silica film. At this stage, the resulting porous film was inspected for a variety of properties and as a result, the film was found to have a refractive index of 1.2215, a relative dielectric constant of 2.05, an elastic modulus of 4.72 GPa and a hardness of 0.57 GPa.

### Example 5

The same procedures (and coating and firing conditions) used in Example 1 were repeated except for using a solution prepared by adding a La₂O₃/H₂O mixture to the coating solution used in Example 1 in such an amount that the content of elemental La was equal to 1000 ppm to thus give a La-containing porous film, followed by subjecting the resulting porous film to the TMCTS treatment similar to that used in Example 1 to thus give a porous silica film. At this stage, the resulting porous film was inspected for a variety of properties and as a result, the film was found to have a refractive index of 1.2774, a relative dielectric constant of 3.48, an elastic modulus of 9.80 GPa and a hardness of 1.08 GPa.

### Example 6

The same procedures (and coating and firing conditions) used in Example 1 were repeated except for using a solution prepared by adding a TI(NO₃)/H₂O mixture to the coating solution used in Example 1 in such an amount that the content of elemental Tl was equal to 1000 ppm to thus give a Tl-containing porous film, followed by subjecting the resulting porous film to the TMCTS treatment similar to that used in Example 1 to thus give a porous silica film. At this stage, the resulting porous film was inspected for a variety of properties and as a result, the film was found to have a refractive index of 1.2100, a relative dielectric constant of 2.15, an elastic modulus of 6.36 GPa and a hardness of 0.73 GPa.

### Example 7

The same procedures (and coating and firing conditions) used in Example 1 were repeated except for using a solution prepared by adding a Pb(NO₃)₂/H₂O mixture to the coating solution used in Example 1 in such an amount that the content of elemental Pb was equal to 1000 ppm to thus give a Pb-containing porous film, followed by subjecting the resulting porous film to the TMCTS treatment similar to that used in Example 1 to thus give a porous silica film. At this stage, the resulting porous film was inspected for a variety of properties and as a result, the film was found to have a refractive index of 1.2388, a relative dielectric constant of 2.44, an elastic modulus of 7.38 GPa and a hardness of 0.84 GPa.

### Example 8

The same procedures (and coating and firing conditions) used in Example 1 were repeated except for using a solution prepared by adding In to the coating solution used in Example 1 in such an amount that the content thereof was equal to 1000 ppm to thus give an In-containing porous film, followed by subjecting the resulting porous film to the TMCTS treatment similar to that used in Example 1 to thus give a porous silica film. At this stage, the resulting porous film was inspected for a variety of properties and as a result, the film was found to have a refractive index of 1.2188, a relative dielectric constant of 2.65, an elastic modulus of 6.72 GPa and a hardness of 0.69 GPa.

### Example 9

The same procedures (and coating and firing conditions) used in Example 1 were repeated except for using a solution prepared by adding a Bi(NO₃)₃/H₂O mixture to the coating solution used in Example 1 in such an amount that the content of elemental Bi was equal to 1000 ppm to thus give a Bi-containing porous film, followed by subjecting the resulting porous film to the TMCTS treatment similar to that used in Example 1 to thus give a porous silica film. At this stage, the resulting porous film was inspected for a variety of properties and as a result, the film was found to have a refractive index of 1.1962, a relative dielectric constant of 2.23, an elastic modulus of 5.15 GPa and a hardness of 0.57 GPa.

The physical properties observed for the porous films prepared in the foregoing Examples 3 to 9 are summarized in the following Table 2:

**Table 2:**

| Ex. No. | Additive Element | Refractive Index | Relative Dielectric Constant (k) | Elastic Modulus (GPa) | Hardness (GPa) |
|---|---|---|---|---|---|
| 3 | P | 1.2680 | 3.00 | 9.37 | 0.97 |
| 4 | Ba | 1.2215 | 2.05 | 4.72 | 0.57 |
| 5 | La | 1.2774 | 3.48 | 9.80 | 1.08 |
| 6 | Tl | 1.2100 | 2.15 | 6.36 | 0.73 |
| 7 | Pb | 1.2388 | 2.44 | 7.38 | 0.84 |
| 8 | In | 1.2188 | 2.65 | 6.72 | 0.69 |
| 9 | Bi | 1.1962 | 2.23 | 5.15 | 0.57 |

### Example 10

The same procedures (and coating and firing conditions) used in Example 1 were repeated except for using a solution prepared by adding a Al(NO₃)₃/Cs(NO₃)/H₂O mixture to the coating solution used in Example 1 in such a manner that the ratio: Al/Cs was 1:1 and that the content of elemental Al/Cs fell within the range of from 0.1 to 5000 ppm on the basis of the total mass of the solution to thus give a porous film, followed by subjecting the resulting porous film to the TMCTS treatment similar to that used in Example 1 to thus give a porous silica film. At this stage, the refractive index, the relative dielectric constant, the elastic modulus and the hardness of the resulting porous film showed the same tendency observed for the porous film obtained in Example 2. More specifically, the refractive index, elastic modulus and hardness of the porous film monotonously increase as the content of the metal elements increases, but the relative dielectric constant thereof is once reduced and then increases when the metal concentration exceeds 5000 ppm since the amount of TMCTS adhered is too high. These facts clearly indicate that when adding a metal element to the porous silica film, the content thereof should be limited to a level of not more than 5000 ppm While if the content of the metal element is 0.01 ppm, the resulting porous film has a low relative dielectric constant, but it has likewise low elastic modulus and hardness and accordingly, the concentration of the metal element is in general not less than 0.1 ppm, preferably not less than 1 ppm and not more than 5000 ppm, while taking into consideration the elastic modulus and hardness of the resulting film.

### Example 11

The same procedures (and coating and firing conditions) used in Example 1 were repeated except that a solution was prepared by adding a Cs(NO₃)/H₂O mixture to the coating solution used in Example 1 in such an amount that the content of elemental Cs was equal to 10 ppm on the basis of the total mass of the solution and used in place of the coating solution used in Example 1 and that all of the heat-treatments were carried out at a temperature of 350°C to thus give a Cs-containing porous film, followed by subjecting the resulting porous film to the TMCTS treatment similar to that used in Example 1 except for using the temperature of 350°C in the treatment to thus give a porous silica film. At this stage, the resulting porous film was inspected for a variety of properties and as a result, the film was found to have a refractive index of 1.2234, a relative dielectric constant of 2.15, an elastic modulus of 4.77 GPa and a hardness of 0.66 GPa. The Cs-containing porous silica film was found to be improved in the refractive index and the mechanical strength by the combination of the incorporation of elemental Cs and the TMCTS treatment even if the heat-treating temperature was reduced from 400°C to 350°C as compared with the porous film prepared in Example 1 free of any elemental Cs.

### Industrial Applicability

The present invention permits the production of a hydrophobic porous film having a low dielectric constant and a low refractive index and excellent in the mechanical strength and therefore, the porous film of the invention can be used, for instance, as electrical insulating films each having a low relative dielectric constant in the fields of semiconductor and a low refractive index film in the field of displays and the like.

## Claims

1. A precursor composition for preparing a porous film, comprising at least one member selected from the group consisting of compounds (A) represented by the following general formula (1):
Si (OR¹) ₄ (1)
and compounds (B) represented by the following general formula (2):
Rₐ(Si)(OR²)₄₋ₐ (2)
- in the foregoing formulas (1) and (2), R¹ represents a monovalent organic group selected from an alkyl group, an aryl group, an allyl group and a glycidyl group; R represents a hydrogen atom, a fluorine atom or a monovalent organic group selected from an alkyl group, an aryl group, an allyl group and a glycidyl group; R² represents a monovalent organic group selected from an alkyl group, an aryl group, an allyl group and a glycidyl group; a is an integer ranging from 1 to 3, provided that R, R¹ and R² may be the same or different - ; at least one surfactant (C) having a molecular weight ranging from 200 to 5000 capable of being thermally decomposed at a temperature of not less than 250 °C; an acidic or basic catalyst; and at least one element (D) selected from the group consisting of amphoteric elements each having an electronegativity of not more than 2.5 and being selected from Al, Zn, Ga, Ge, As, In, Sn, Sb, elements each having an ionic radius of not less than 160 pm (1.6 Å) and being selected from P, Se, Te, Rb, Cs, and elements each having an atomic weight of not less than 130 and being selected from elements of the lanthanoid series and Cs, Ba, La, Hf, Ta, W, Re, Os, Ir, Pt, Au, Hg, Tl, Pb, Bi, Po, At, wherein the element (D) is contained in an amount ranging from 50 to 5000 ppm on the basis of the precursor composition.

2. The precursor composition for preparing a porous film as set forth in claim 1, wherein the content of metallic ion impurities other than the element (D) included in the precursor composition is not more than 10 ppb.

3. A method for the preparation of a precursor composition according to one of claims 1 to 2, comprising the step of blending, in an organic solvent, at least one member selected from the group consisting of compounds (A) represented by the following general formula (1):
Si(OR¹)₄ (1)
and compounds (B) represented by the following general formula (2) :
Rₐ(Si)(OR²)₄₋ₐ (2)
- in the foregoing formulas (1) and (2), R¹ represents a monovalent organic group selected from an alkyl group, an aryl group, an allyl group and a glycidyl group; R represents a hydrogen atom, a fluorine atom or a monovalent organic group selected from an alkyl group, an aryl group, an allyl group and a glycidyl group; R² represents a monovalent organic group selected from an alkyl group, an aryl group, an allyl group and a glycidyl group; a is an integer ranging from 1 to 3, provided that R, R¹ and R² may be the same or different - ; at least one surfactant (C) having a molecular weight ranging from 200 to 5000 capable of being thermally decomposed at a temperature of not less than 250 °C; an acidic or basic catalyst ; and at least one element (D) selected from the group consisting of amphoteric elements each having an electronegativity of not more than 2.5 and being selected from Al, Zn, Ga, Ge, As, In, Sn, Sb, elements each having an ionic radius of not less than 160 pm (1.6 Å) and being selected from P, Se, Te, Rb, Cs, and elements each having an atomic weight of not less than 130 and being selected from elements of the lanthanoid series and Cs, Ba, La, Hf, Ta, W, Re, Os, Ir, Pt, Au, Hg, Tl, Pb, Bi, Po, At, or at least one compound containing the element (D), wherein the element (D) is contained in an amount ranging from 50 to 5000 ppm on the basis of the precursor composition.

4. A method for the preparation of a precursor composition according to one of claims 1 to 2 for use in the formation of a porous film, comprising the steps of
- blending, in an organic solvent, at least one member selected from the group consisting of compounds (A) represented by the following general formula (1):
Si(OR¹)₄ (1)
and compounds (B) represented by the following general formula (2):
R**ₐ**(Si)(OR²)₄₋ₐ (2)
- in the foregoing formulas (1) and (2), R¹ represents a monovalent organic group selected from an alkyl group, an aryl group, an allyl group and a glycidyl group; R represents a hydrogen atom, a fluorine atom or a monovalent organic group selected from an alkyl group, an aryl group, an allyl group and a glycidyl group; R² represents a monovalent organic group selected from an alkyl group, an aryl group, an allyl group and a glycidyl group; a is an integer ranging from 1 to 3, provided that R, R¹ and R² may be the same or different - ; at least one surfactant (C) having a molecular weight ranging from 200 to 5000 and capable of being thermally decomposed at a temperature of not less than 250 °C; and an acidic or basic catalyst;
- adding, to the resulting mixed solution, at least one element (D) selected from the group consisting of amphoteric elements each having an electronegativity of not more than 2.5 and being selected from Al, Zn, Ga, Ge, As, In, Sn, Sb, elements each having an ionic radius of not less than 160 pm (1.6 Å) and being selected from P, Se, Te, Rb, Cs, and elements each having an atomic weight of not less than 130 and being selected from elements of the lanthanoid series and Cs, Ba, La, Hf, Ta, W, Re, Os, Ir, Pt, Au, Hg, Tl, Pb, Bi, Po, At, or at least one compound containing the at least one element (D); and mixing the solution and the at least one element (D) or the compound containing the at least one element (D), wherein the element (D) is contained in an amount ranging from 50 to 5000 ppm on the basis of the precursor composition.

5. The method for the preparation of the precursor composition as set forth in any one of claims 3 to 4, wherein the content of metallic ion impurities other than the element (D) included in the precursor composition is not more than 10 ppb.

6. A method for preparing a porous film **comprising** the steps of preparing a film on a substrate using a precursor composition as set forth in any one of claims 1 or 2 or the precursor composition for use in the preparation of a porous film prepared according to the method as set forth in any one of claims 3 to 5; and then subjecting the resulting film to a heat-treatment at a temperature of not less than 250°C to make, thermally decompose the thermally decomposable organic surfactant compound present in the precursor composition and to thus prepare a porous film.

7. A method for the preparation of a porous film **comprising** the step of subjecting a hydrophobic compound having at least one group selected from hydrophobic groups and polymerizable groups to a gas-phase reaction at a temperature ranging from 100 to 600°C in the presence of the porous film prepared according to the method as set forth in claim 6 to thus improve the quality of the porous film.

8. The method as set forth in claim 7, wherein the hydrophobic compound is one having at least one hydrophobic group selected from the group consisting of an alkyl group having 1 to 6 carbon atoms and a C₆H₅ group and at least one polymerizable group selected from the group consisting of hydrogen atom, OH group and a halogen atom.

9. The method as set forth in claim 7, wherein the hydrophobic compound is an organic silicon atom-containing compound having at least one bonding unit represented by the formula: Si-X-Si - in the formula, X represents an oxygen atom, an NR³ group, a -CₙH₂ₙ group, or a
- C₆H₄ group, R³ represents -CₘH₂ₘ₊₁ group or a -C₆H₅ group, n is an integer of 1 or 2, m is an integer ranging from 1 to 6 - and at least two bonding units represented by the formula: Si-A
- in the formula, A represents a hydrogen atom, a hydroxyl group, an -OC_{b}H_{2b+1} group or a halogen atom, provided that a plurality of groups A present in the same molecule may be the same or different, and b is an integer ranging from 1 to 6 - .

10. A porous film obtained according to the method as set forth in any one of claims 6 to 9.

11. A semiconductor device manufactured by the use of a porous film obtained according to the method for the preparation of a as set forth in any one of claims 6 to 9.

## Patentansprüche

1. Vorläuferzusammensetzung zur Herstellung eines porösen Films, enthaltend mindestens ein Mitglied aus der Gruppe bestehend aus Verbindungen (A) gemäss der folgenden allgemeinen Formel (1):
Si (OR¹) ₄ (1)
und Verbindungen (B) gemäss der folgenden allgemeinen Formel (2):
Rₐ (Si) (OR²)₄₋a (2)
- in den vorstehenden Formeln (1) und (2) steht R¹ für eine aus einer Alkylgruppe, einer Arylgruppe, einer Allylgruppe und einer Glycidylgruppe ausgewählte einwertige organische Gruppe; R steht für ein Wasserstoffatom, ein Fluoratom oder eine aus einer Alkylgruppe, einer Arylgruppe, einer Allylgruppe und einer Glycidylgruppe ausgewählte einwertige organische Gruppe; R² steht für eine aus einer Alkylgruppe, einer Arylgruppe, einer Allylgruppe und einer Glycidylgruppe ausgewählte einwertige organische Gruppe; a ist eine ganze Zahl von 1 bis 3, wobei R, R¹ und R² gleich oder verschieden sein können - ; mindestens ein Tensid (C) mit einem Molekulargewicht im Bereich von 200 bis 5000, das bei einer Temperatur nicht unter 250 °C thermisch abbaubar ist; einen sauren oder basischen Katalysator; sowie mindestens ein Element (D) aus der Gruppe bestehend aus amphoteren Elementen mit einer Elektronegativität von jeweils nicht über 2,5 und ausgewählt aus Al, Zn, Ga, Ge, As, In, Sn, Sb, Elementen mit einem Ionenradius von jeweils nicht unter 160 pm (1.6 Å) und ausgewählt aus P, Se, Te, Rb, Cs, und Elementen mit einem Atomgewicht nicht unter 130 und ausgewählt aus Elementen der Lanthanidenreihe und Cs, Ba, La, Hf, Ta, W, Re, Os, Ir, Pt, Au, Hg, Tl, Pb, Bi, Po, At, wobei das Element (D) bezogen auf die Vorläuferzusammensetzung in einer Menge im Bereich von 50 bis 5000 ppm enthalten ist.

2. Vorläuferverbindung zur Herstellung eines porösen Films nach Anspruch 1, wobei der Gehalt an Metallionen-Fremdstoffen ausser dem in der Vorläuferverbindung enthaltenen Element (D) nicht mehr als 10 ppb beträgt.

3. Verfahren zur Herstellung einer Vorläuferverbindung nach einem der Ansprüche 1 bis 2, enthaltend als Schritt das Vermischen in einem organischen Lösungsmittel mindestens eines Mitglieds aus der Gruppe bestehend aus Verbindungen (A) gemäss der folgenden allgemeinen Formel (1):
Si(OR¹)₄ (1)
sowie Verbindungen (B) gemäss der folgenden allgemeinen Formel (2) :
Rₐ (Si) (OR²) ₄₋ₐ (2)
- in den vorstehenden Formeln (1) und (2) steht R1 für eine aus einer Alkylgruppe, einer Arylgruppe, einer Allylgruppe und einer Glycidylgruppe ausgewählte einwertige organische Gruppe; R steht für ein Wasserstoffatom, ein Fluoratom oder eine aus einer Alkylgruppe, einer Arylgruppe, einer Allylgruppe und einer Glycidylgruppe ausgewählte einwertige organische Gruppe; R² steht für eine aus einer Alkylgruppe, einer Arylgruppe, einer Allylgruppe und einer Glycidylgruppe ausgewählte einwertige organische Gruppe; a ist eine ganze Zahl von 1 bis 3, wobei R, R1 und R² gleich oder verschieden sein können - ; mindestens eines Tensids (C) mit einem Molekulargewicht im Bereich von 200 bis 5000, das bei einer Temperatur nicht unter 250 °C thermisch abbaubar ist; eines sauren oder basischen Katalysators; sowie mindestens eines Elements (D) aus der Gruppe bestehend aus amphoteren Elementen mit einer Elektronegativität von jeweils nicht über 2,5 und ausgewählt aus Al, Zn, Ga, Ge, As, In, Sn, Sb, Elementen mit einem Ionenradius von jeweils nicht unter 160 pm (1.6 Å) und ausgewählt aus P, Se, Te, Rb, Cs, und Elementen mit einem Atomgewicht nicht unter 130 und ausgewählt aus Elementen der Lanthanidenreihe und Cs, Ba, La, Hf, Ta, W, Re, Os, Ir, Pt, Au, Hg, Tl, Pb, Bi, Po, At, oder mindestens einer das Element (D) enthaltenden Verbindung, wobei das Element (D) bezogen auf die Vorläuferzusammensetzung in einer Menge im Bereich von 50 bis 5000 ppm enthalten ist.

4. Verfahren zur Herstellung einer Vorläuferzusammensetzung nach einem der Ansprüche 1 bis 2 zur Verwendung bei der Bildung eines porösen Films, enthaltend als Schritte
- Vermischen, in einem organischen Lösungsmittel, mindestens eines Mitglieds aus der Gruppe bestehend aus Verbindungen (A) gemäss der folgenden allgemeinen Formel (1):
Si (OR¹) ₄ (1)
sowie Verbindungen (B) gemäss der folgenden allgemeinen Formel (2):
Rₐ(Si)(OR²)₄₋ₐ (2)
- in den vorstehenden Formeln (1) und (2) steht R¹ für eine aus einer Alkylgruppe, einer Arylgruppe, einer Allylgruppe und einer Glycidylgruppe ausgewählte einwertige organische Gruppe; R steht für ein Wasserstoffatom, ein Fluoratom oder eine aus einer Alkylgruppe, einer Arylgruppe, einer Allylgruppe und einer Glycidylgruppe ausgewählte einwertige organische Gruppe; R² steht für eine aus einer Alkylgruppe, einer Arylgruppe, einer Allylgruppe und einer Glycidylgruppe ausgewählte einwertige organische Gruppe; a ist eine ganze Zahl von 1 bis 3, wobei R, R¹ und R² gleich oder verschieden sein können - ; mindestens eines Tensids (C) mit einem Molekulargewicht im Bereich von 200 bis 5000, das bei einer Temperatur nicht unter 250 °C thermisch abbaubar ist; und eines sauren oder basischen Katalysators;
- Zugabe, zur resultierenden gemischten Lösung, mindestens eines Elements (D) aus der Gruppe bestehend aus amphoteren Elementen mit einer Elektronegativität von jeweils nicht über 2,5 und ausgewählt aus Al, Zn, Ga, Ge, As, In, Sn, Sb, Elementen mit einem Ionenradius von jeweils nicht unter 160 pm (1.6 Å) und ausgewählt aus P, Se, Te, Rb, Cs, und Elementen mit einem Atomgewicht nicht unter 130 und ausgewählt aus Elementen der Lanthanidenreihe und Cs, Ba, La, Hf, Ta, W, Re, Os, Ir, Pt, Au, Hg, Tl, Pb, Bi, Po, At, oder mindestens einer das mindestens eine Element (D) enthaltenden Verbindung, und Mischen der Lösung und des mindestens einen Elements (D) oder der das mindestens eine Element (D) enthaltenden Verbindung, wobei das Element (D) bezogen auf die Vorläuferzusammensetzung in einer Menge im Bereich von 50 bis 5000 ppm enthalten ist.

5. Verfahren zur Herstellung einer Vorläuferverbindung nach einem der Ansprüche 3 bis 4, wobei der Gehalt an Metallionen-Fremdstoffen ausser dem in der Vorläuferverbindung enthaltenen Element (D) nicht mehr als 10 ppb beträgt.

6. Verfahren zur Herstellung eines porösen Films, enthaltend als Schritte die Herstellung eines Films auf einem Substrat mittels einer Vorläuferzusammensetzung nach einem der Ansprüche 1 oder 2 oder der gemäss dem Verfahren nach einem der Ansprüche 3 bis 5 hergestellten Vorläuferzusammensetzung zur Verwendung bei der Bildung eines porösen Films; und nachfolgende Wärmebehandlung des resultierenden Films bei einer Temperatur nicht unter 250 °C, um die in der Vorläuferverbindung vorhandene thermisch abbaubare organische Tensidverbindung thermisch abzubauen und so einen porösen Film herzustellen.

7. Verfahren zur Herstellung eines porösen Films, enthaltend als Schritt die Anwendung einer Gasphasenreaktion bei einer Temperatur im Bereich von 100 bis 600 °C in der Gegenwart des gemäss dem Verfahren nach Anspruch 6 hergestellten porösen Films auf eine hydrophobe Verbindung, die mindestens eine aus hydrophoben Gruppen und polymerisierbaren Gruppen ausgewählte Gruppe aufweist, um so die Güte des porösen Films zu verbessern.

8. Verfahren nach Anspruch 7, wobei die hydrophobe Verbindung eine Verbindung ist, die mindestens eine aus der Gruppe bestehend aus einer Alkylgruppe mit 1 bis 6 Kohlenstoffatomen und einer C₆H₅-Gruppe ausgewählte hydrophobe Gruppe und mindestens eine aus der Gruppe bestehend aus Wasserstoffatom, OH-Gruppe und Halogenatom ausgewählte polymerisierbare Gruppe aufweist.

9. Verfahren nach Anspruch 7, wobei die hydrophobe Verbindung eine siliziumatomhaltige organische Verbindung ist mit mindestens einer Bindungseinheit gemäss der Formel: Si-X-Si - in der Formel steht X für ein Sauerstoffatom, eine NR³-Gruppe, eine -CₙH₂ₙ-Gruppe oder eine -C₆H₄-Gruppe, R³ steht für eine -CₘH₂ₘ₊₁-Gruppe oder eine -C₆H₅-Gruppe, n ist eine ganze Zahl von 1 oder 2, m ist eine ganze Zahl von 1 bis 6 - und mindestens zwei Bindungseinheiten gemäss der Formel: Si-A - in der Formel steht A für ein Wasserstoffatom, eine Hydroxylgruppe, eine -OC_{b}H_{2b+1}-Gruppe oder ein Halogenatom, wobei mehrere im gleichen Molekül enthaltene Gruppen A gleich oder unterschiedlich sein können, und b ist eine ganze Zahl von 1 bis 6 - .

10. Gemäss dem Verfahren nach einem der Ansprüche 6 bis 9 erhaltener poröser Film.

11. Halbleiterbauelement, hergestellt unter Verwendung eines gemäss dem Verfahren nach einem der Ansprüche 6 bis 9 erhaltenen porösen Films.

## Revendications

1. Composition de précurseur pour la préparation d'un film poreux, comprenant au moins un membre choisi parmi le groupe comprenant des composés (A) représentés par la formule générale suivante (1):
Si(OR¹)₄ (1)
et des composés (B) représentés par la formule générale suivante (2):
Rₐ (Si)(OR²)₄₋ₐ (2)
- dans les formules précédentes (1) et (2), R¹ représente un groupe organique monovalent choisi parmi un groupe alkyle, un groupe aryle, un groupe allyle et un groupe glycidyle; R représente un atome d'hydrogène, un atome de fluor ou un groupe organique monovalent choisi parmi un groupe alkyle, un groupe aryle, un groupe allyle et un groupe glycidyle; R² représente un groupe organique monovalent choisi parmi un groupe alkyle, un groupe aryle, un groupe allyle et un groupe glycidyle; a est un nombre entier de 1 à 3, R, R¹ et R² pouvant être identiques ou différents - ; au moins un surfactant (C) ayant un poids moléculaire de 200 à 5000 et décomposable par voie thermique à une température non inférieure à 250 °C; un catalyseur acide ou basique; et au moins un élément (D) choisi parmi le groupe comprenant des éléments amphotères ayant chacun une électronégativité ne dépassant pas 2,5 et choisis parmi Al, Zn, Ga, Ge, As, In, Sn, Sb, des éléments ayant un rayon ionique respectif non inférieur à 160 pm (1,6 Å) et choisis parmi P, Se, Te, Rb, Cs, et des éléments ayant un poids atomique respectif non inférieur à 130 et choisis parmi les lanthanides et Cs, Ba, La, Hf, Ta, W, Re, Os, Ir, Pt, Au, Hg, Tl, Pb, Bi, Po, At, où l'élément (D) est contenu en une quantité de 50 à 5000 ppm sur la base de la composition de précurseur.

2. Composition de précurseur pour la préparation d'un film poreux selon la revendication 1, où le contenu en impuretés sous forme d'ions métalliques autres que l'élément (D) inclus dans la composition de précurseur ne dépasse pas 10 ppb.

3. Procédé de préparation d'une composition de précurseur selon l'une des revendications 1 à 2, comprenant l'étape consistant à mélanger, dans un solvant organique, au moins un membre choisi parmi le groupe comprenant des composés (A) représentés par la formule générale suivante (1):
Si (OR¹) ₄ (1)
et des composés (B) représentés par la formule générale suivante (2):
Rₐ (Si) (OR²) ₄₋ₐ (2)
- dans les formules précédentes (1) et (2), R¹ représente un groupe organique monovalent choisi parmi un groupe alkyle, un groupe aryle, un groupe allyle et un groupe glycidyle; R représente un atome d'hydrogène, un atome de fluor ou un groupe organique monovalent choisi parmi un groupe alkyle, un groupe aryle, un groupe allyle et un groupe glycidyle; R² représente un groupe organique monovalent choisi parmi un groupe alkyle, un groupe aryle, un groupe allyle et un groupe glycidyle; a est un nombre entier de 1 à 3, R, R¹ et R² pouvant être identiques ou différents - ; au moins un surfactant (C) ayant un poids moléculaire de 200 à 5000 et décomposable par voie thermique à une température non inférieure à 250 °C; un catalyseur acide ou basique; et au moins un élément (D) choisi parmi le groupe comprenant des éléments amphotères ayant chacun une électronégativité ne dépassant pas 2,5 et choisis parmi Al, Zn, Ga, Ge, As, In, Sn, Sb, les éléments ayant un rayon ionique respectif non inférieur à 160 pm (1,6 Å) et choisis parmi P, Se, Te, Rb, Cs, et des éléments ayant un poids atomique respectif non inférieur à 130 et choisis parmi les lanthanides et Cs, Ba, La, Hf, Ta, W, Re, Os, Ir, Pt, Au, Hg, Tl, Pb, Bi, Po, At, ou au moins un composé contenant l'élément (D), où l'élément (D) est contenu en une quantité de 50 à 5000 ppm sur la base de la composition de précurseur.

4. Procédé de préparation d'une composition de précurseur selon l'une des revendications 1 à 2 pour utilisation dans la formation d'un film poreux, comprenant les étapes consistant à
- mélanger, dans un solvant organique, au moins un membre choisi parmi le groupe comprenant des composés (A) représentés par la formule générale suivante (1):
Si (OR¹) ₄ (1)
et des composés (B) représentés par la formule générale suivante (2):
Rₐ(Si)(OR²)₄₋ₐ (2)
- dans les formules précédentes (1) et (2), R¹ représente un groupe organique monovalent choisi parmi un groupe alkyle, un groupe aryle, un groupe allyle et un groupe glycidyle; R représente un atome d'hydrogène, un atome de fluor ou un groupe organique monovalent choisi parmi un groupe alkyle, un groupe aryle, un groupe allyle et un groupe glycidyle; R² représente un groupe organique monovalent choisi parmi un groupe alkyle, un groupe aryle, un groupe allyle et un groupe glycidyle; a est un nombre entier de 1 à 3, R, R¹ et R² pouvant être identiques ou différents - ; au moins un surfactant (C) ayant un poids moléculaire de 200 à 5000 et décomposable par voie thermique à une température non inférieure à 250 °C; et un catalyseur acide ou basique;
- ajouter, à la solution mélangée résultante, au moins un élément (D) choisi parmi le groupe comprenant des éléments amphotères ayant chacun une électronégativité ne dépassant pas 2,5 et choisis parmi Al, Zn, Ga, Ge, As, In, Sn, Sb, des éléments ayant un rayon ionique respectif non inférieur à 160 pm (1,6 Å) et choisis parmi P, Se, Te, Rb, Cs, et des éléments ayant un poids atomique respectif non inférieur à 130 et choisis parmi les lanthanides et Cs, Ba, La, Hf, Ta, W, Re, Os, Ir, Pt, Au, Hg, Tl, Pb, Bi, Po, At, ou au moins un composé contenant ledit au moins un élément (D), et à mélanger la solution et ledit au moins un élément (D) ou le composé contenant ledit au moins un élément (D), où l'élément (D) est contenu en une quantité de 50 à 5000 ppm sur la base de la composition de précurseur.

5. Procédé de préparation d'une composition de précurseur selon l'une des revendications 3 à 4, où le contenu en impuretés sous forme d'ions métalliques autres que l'élément (D) inclus dans la composition de précurseur ne dépasse pas 10 ppb.

6. Procédé de préparation d'un film poreux, comprenant les étapes de préparer un film sur un substrat à l'aide d'une composition de précurseur selon l'une quelconque des revendications 1 ou 2 ou de la composition de précurseur pour utilisation dans la préparation d'un film poreux préparée d'après le procédé selon l'une quelconque des revendications 3 à 5, et de soumettre ensuite le film résultant à un traitement thermique à une température non inférieure à 250 °C afin de décomposer par voie thermique le composé surfactant décomposable par voie thermique présent dans la composition de précurseur et de préparer ainsi un film poreux.

7. Procédé de préparation d'un film poreux, comprenant l'étape consistant à soumettre un composé hydrophobe comprenant au moins un groupe choisi parmi des groupes hydrophobes et des groupes polymérisables, à une réaction en phase gazeuse à une température de 100 à 600 °C en présence du film poreux préparé d'après le procédé selon la revendication 6 afin d'améliorer ainsi la qualité du film poreux.

8. Procédé selon la revendication 7, où le composé hydrophobe est un composé comprenant au moins un groupe hydrophobe choisi parmi le groupe comprenant un groupe alkyle ayant 1 à 6 atomes de carbone et un groupe C₆H₅ et au moins un groupe polymérisable choisi parmi le groupe comprenant atome d'hydrogène, groupe OH et atome d'halogène.

9. Procédé selon la revendication 7, où le composé hydrophobe est un composé organique contenant des atomes de silicium qui comprend au moins une unité de liaison représentée par la formule: Si-X-Si - dans la formule, X représente un atome d'oxygène, un groupe NR³, un groupe -CₙH₂ₙ ou un groupe -C₆H₄, R³ représente un groupe -CₘH₂ₘ₊₁ ou un groupe -C₆H₅, n est un nombre entier de 1 ou 2, m est un nombre entier de 1 à 6 - et au moins deux unités de liaison représentées par la formule: Si-A - dans la formule, A représente un atome d'hydrogène, un groupe hydroxyle, un groupe -OC_{b}H_{2b+1} ou un atome d'halogène, étant entendu que plusieurs groupes A présents dans la même molécule peuvent être identiques ou différents, et b est un nombre entier de 1 à 6 - .

10. Film poreux obtenu d'après le procédé selon l'une quelconque des revendications 6 à 9.

11. Dispositif à semi-conducteur fabriqué à l'aide du film poreux obtenu d'après le procédé selon l'une quelconque des revendications 6 à 9.
